# EUROPEAN PATENT SPECIFICATION

(11) **EP 4 154 019 B1**
(45) Date of publication and mention of the grant of the patent: **08.01.2025**
(21) Application number: 21727529.6
(22) Date of filing: 18.05.2021
(51) Int. Cl.: G01P 15/097, B81B 5/00

(54) **MODE LOCALISED ACCELEROMETER**
MODUSLOKALISIERTER BESCHLEUNIGUNGSMESSER
ACCÉLÉROMÈTRE LOCALISÉ PAR MODE

(30) Priority: 21.05.2020 GB 202007592
(43) Date of publication of application: 29.03.2023
(73) Proprietor: Silicon Microgravity Limited, Cambridge Innovation Park, Waterbeach, Cambridgeshire CB25 9GL (GB)
(72) Inventor: SESHIA, Ashwin, Cambridge Cambridgeshire CB3 0FF (GB); ZHAO, Chun, Cambridge Cambridgeshire CB3 0FF (GB); PANDIT, Milind, Cambridge Cambridgeshire CB25 9GL (GB)
(74) Representative: Reddie & Grose LLP
(86) International application number: PCT/GB2021/051198
(87) International publication number: WO 2021/234373

(56) References cited:
- EP-A1- 2 577 324
- WO-A1-2011/148137
- WO-A1-2016/122960
- WO-A1-2018/197857

## Description

### Field of the Invention

The invention relates to accelerometers. In particular, the invention relates to accelerometer designs that are highly sensitive to small changes in acceleration and can be used as gravimeters.

### Background to the Invention

A resonant sensor is an oscillator whose output resonant frequency is a function of an input measurand. In other words, the output of a resonant sensor corresponds to the shift in resonant frequency of a mechanical microstructure that gets tuned in accordance with a change in a physical quantity to be measured.

There has been an increased interest over the past few years in the development of high precision micromachined 'all-silicon' resonant micro-accelerometers. This interest has been triggered due to the recent growth in demand for miniature high precision motion sensors within the aerospace, automotive and even the consumer-electronics markets. Resonant micro-accelerometers fabricated using silicon micromachining techniques present a number of significant advantages, the biggest being economy. These silicon resonant micro-accelerometers not only boast improved sensitivity and resolution relative to their more traditional capacitive detection based counterparts with similar device footprints, but have also been shown to provide enhanced dynamic range making them ideal candidates for potential application in numerous motion sensing applications within the identified markets. One potential sensing application is gravimetry. Resonant accelerometers can be designed to provide a low-noise response for near-DC measurements (suitable for applications in gravimetry) and a wide dynamic range enabling measurements over the entire +/-1g regime.

Accelerometer designs that exploit mode localization between two or more weakly coupled resonators have been proposed. The variations in the eigenstates (which refer to the relative amplitudes at the resonant frequencies measured from each of the resonators) due to induced strain modulation one of the resonators, yields a measure of the inertial force on the sensor. Measuring such eigenstate variations induced by mode localization offers two key advantages over conventional resonant frequency shift based measurements: insensitivity to unwanted environmental variations; and orders of magnitude enhancement in the output sensitivity and consequently, the resolution of such sensors.

It is an object of the present invention to provide a resonant accelerometer that provides the advantages of using mode localization but that has an improved scale factor when compared to previous designs.

WO2018/197857 A1 discloses a resonant sensor comprising a substrate and a proof mass suspended from the substrate by one or more flexures to allow the proof mass to move relative to the frame along a sensitive axis. First and second resonant elements are connected between the frame and the proof mass. Drive and sensing circuitry is configured to drive the first resonant element in a first mode, drive the second resonant element in a second mode different to the first mode, and determine a measure of acceleration.

WO 2016/122960 A1 discloses a MEMS sensor that comprises a substrate and an anchor region coupled to the substrate. At least one support arm is coupled to the anchor region, at least two guiding arms are coupled to the at least one support arm, and a plurality of sensing elements are disposed on the at least two guiding arms to measure motion of the at least two guiding arms relative to the substrate. A proof mass system comprising at least one mass is coupled to each of the at least two guiding arms by a set of springs. The proof mass system is disposed outside the anchor region, the at least one support arm, the at least two guiding arms, the set of springs, and the plurality of sensing elements.

### Summary of the Invention

According to the invention an accelerometer according to claim 1 is provided. Other embodiments are covered by the dependent claims.

### Brief description of the Drawings

Embodiments of the invention will now be described in detail, by way of example only, with reference to the accompanying drawings, in which:
Figure 1 is a schematic illustration of a first embodiment of the invention;
Figure 2 illustrates drive and sensing circuitry for use with the embodiment of Figure 1;
Figure 3 is a flow diagram of the control process for the circuitry of Figure 2;
Figure 4 is a schematic illustration of a second embodiment of the invention;
Figure 5 is a schematic illustration of a third embodiment of the invention;
Figure 6 is a schematic illustration of a fourth embodiment of the invention;
Figure 7 is a schematic illustration of resonant elements that can be used; and
Figure 8 is a schematic illustration of a borehole tool including an accelerometer.

### Detailed Description

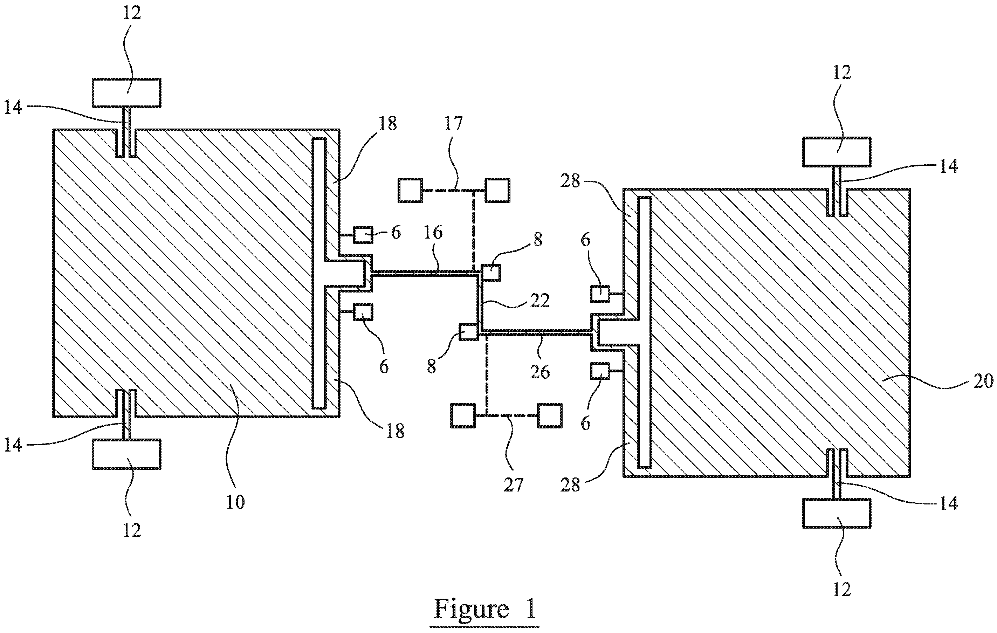

Figure 1 is a schematic illustration of a top view of an accelerometer in accordance with the present invention. The accelerometer is advantageously fabricated entirely from a single semiconductor wafer, such as a silicon-on-insulator (SOI) wafer.

The accelerometer comprises a first proof mass 10 and a second proof mass 20. The first proof mass is suspended from a frame 12 by flexures 14 so as to allow movement of the first proof mass along an axis, towards and away from the second proof mass. The second proof mass 20 is suspended from the frame 12 by flexures 14 in the same way, so as to allow movement of the second proof mass along the same axis, towards and away from the first proof mass. The axis is the sensitive axis of the accelerometer.

A first resonant element 16 is connected between an anchor 8 and the first proof mass 10. The anchor 8 is part of the frame 12. The first resonant element extends along the sensitive axis. The first resonant element 16 is connected to the first proof mass 10 through amplifying levers 18. The amplifying levers 18 are fixed to the frame at pivot points 6.

A second resonant element 26, identical to the first resonant element 16, is connected between a second anchor 8 and the second proof mass 20. The second proof mass is also identical to first proof mass, and the force amplifying levers 28 are identical to the force amplifying levers 18. The second resonant element extends along the same sensitive axis as the first resonant element, but in an opposite direction. This means that when the accelerometer undergoes an acceleration, the second resonant element 26 experiences an equal but opposite strain to the first resonant element 16.

The first and second resonant elements 16, 26 are coupled by a coupling beam 22. In this example the coupling beam 22 is a simple linear beam. The coupling beam is formed from the same silicon wafer as the resonant elements.

Energy can be transferred from one resonant element to the other through the coupling beam. When the resonant elements experience opposite strain to one another, and so have different resonant properties, energy can be localised more in one resonant element than the other. This phenomenon is often referred to as mode localisation.

The amount of mode localisation is dependent on the degree to which the strain on the first and second resonant elements is different. So the relative amplitude of vibration of the first and second resonant elements can be used to provide a measure of acceleration experienced by the proof masses. In fact, measuring amplitude variations induced by mode localisation provides a high resolution determination of acceleration that is relatively insensitive to environmental variation. This is described fully in WO2011/148137.

With the arrangement of Figure 1, because one resonant element undergoes compression while the other undergoes tension, a level of common mode rejection can be achieved using only a single pair of coupled resonant elements. This means that for a given size of accelerometer, the size, and hence mass, of the proof mass can greater than when two pairs of resonant elements are used to provide a differential output. Furthermore, locating the resonant element assembly at the centre of the structure allows for better matching between the two resonant elements, improving common mode rejection.

The weaker the coupling between the resonant elements the more pronounced the mode localisation and so the high resolution the measurement. However, the weaker the coupling is between the resonant elements the closer the resonant modes are in frequency. The coupling must therefore be non-zero and sufficient for each resonant mode to be resolvable from each other. In other words the coupling must be strong enough that there is no modal overlap in the coupled response of the system. In order to ensure the structure is robust and can be consistently produced, the coupling beam needs to have sufficient thickness.

The coupling beam between the first and second resonant element is positioned close to the anchors 8. Positioning the coupling beam 22 closer to a node of the mode of vibration in use reduces the strength of coupling when compared to positioning the coupling beam closer to anti-node of the mode of vibration, and so increases the scale factor of the accelerometer.

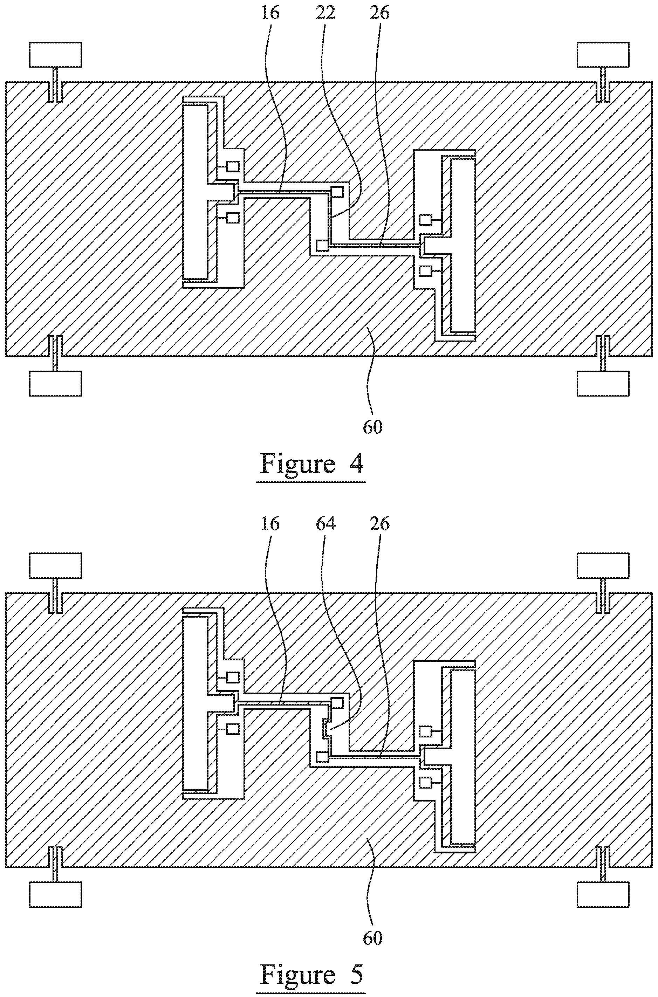

The coupling between the first and second resonant element can be achieved electrostatically instead of by a coupling beam. If a mechanical linkage is used, other shapes of beam are possible, as described with reference to Figure 5 below.

In the embodiment of Figure 1 third and fourth resonant elements are shown in dotted line. The third resonant element 17 is coupled to the first resonant element 16 by a mechanical linkage. The fourth resonant element 27 is coupled to the second resonant element 26 by a mechanical linkage. The third and fourth resonant elements are structurally identical to one another (and may be identical to the first and second resonant elements), and are coupled to the frame, but they are not coupled to either of the proof masses. The provision of further coupled resonant elements in this manner can enhance mode localisation and thereby improve the sensitivity of the measurement.

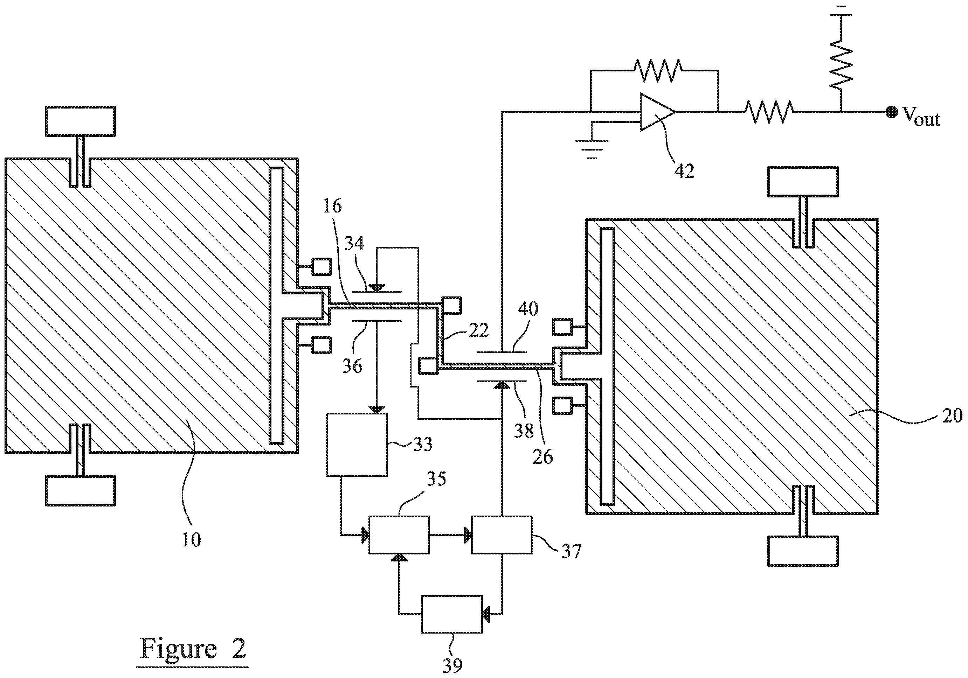

Figure 2 illustrates an arrangement for driving the resonant elements of Figure 1 and for providing an output measure of acceleration. In Figure 2, third and fourth resonant elements are not provided.

The first and second resonant elements 16 and 26 are driven by an AC voltage signal from two separate drive electrodes 34 and 38. The same AC signal is applied to each drive electrode. The amplitude of oscillation of the first resonant element 16 is maintained at a constant level by sensing off electrode 36. The output from electrode 36 is fed into a control circuit, and the output of the control circuit fed back to drive electrodes 34 and 38. The first stage of the control circuit is a gain element 33 that provides a fairly large initial gain before feeding the signal into a variable gain amplifier (VGA) 35. The VGA 35 consists of an amplifier that adjusts its gain in accordance to a control signal (from an automatic gain control (AGC) circuit 39) and feeds the output to a buffer 37. The AGC 39 consists of a circuit that detects the output of the first stage gain element using a peak detector (that compares the peak amplitude of the output arising from the first gain stage with that of a reference signal) and accordingly controls the gain of the first stage gain element to maintain the output at a constant peak amplitude. The controlled output signal from the buffer 37 is, in turn, used to drive the resonant elements in the chosen mode of oscillation. The modal amplitudes of the second resonant element (at the resonant mode wherein the oscillations are sustained) is then read out from sense electrode 40.

Sensing of the amplitude of vibration may be implemented in several ways. In the embodiment shown in Figure 2, the sensing of the amplitude of vibration of the first and second resonant elements may be achieved by measuring the motional current of the resonant elements as they oscillate from the sensing electrodes 36 and 40 respectively. Silicon also exhibits a strong piezoresistive effect, so the resistance of a silicon resonant element will change as it oscillates which may also be used as an alternative readout mechanism. Alternatively, the sensing means may comprise electrodes mounted adjacent to the first and second resonant elements to allow for capacitive sensing. Other possibilities for the sensing means include optical sensing of the oscillation of the first resonant element or even electro-magnetic transduction.

The output from the sense electrode 40 is fed into a trans-resistance amplifier circuit 42 to convert the current signal from electrode 40 into a voltage signal that may be used to directly calculate an amplified measure of the modal amplitude variation of the second resonant element 26, from which any induced changes in the stiffness of the first resonant element 1 may be evaluated. From the change in stiffness, acceleration can be determined.

If further coupled resonant elements are provided, the drive and sense arrangement can be extended, for instance by driving only the first and second resonant elements and sensing the response of all the resonant elements. Alternatively, all of the coupled resonant elements can be driven and sensed. Any number of coupled resonant elements can be used.

Instead of using feedback control to maintain the first resonant element at a constant amplitude, it is possible to read the amplitude of both the first and second resonant elements and determine the ratio of the amplitudes in order to provide a measure of acceleration. This drive and sensing scheme is described in WO2011/148137.

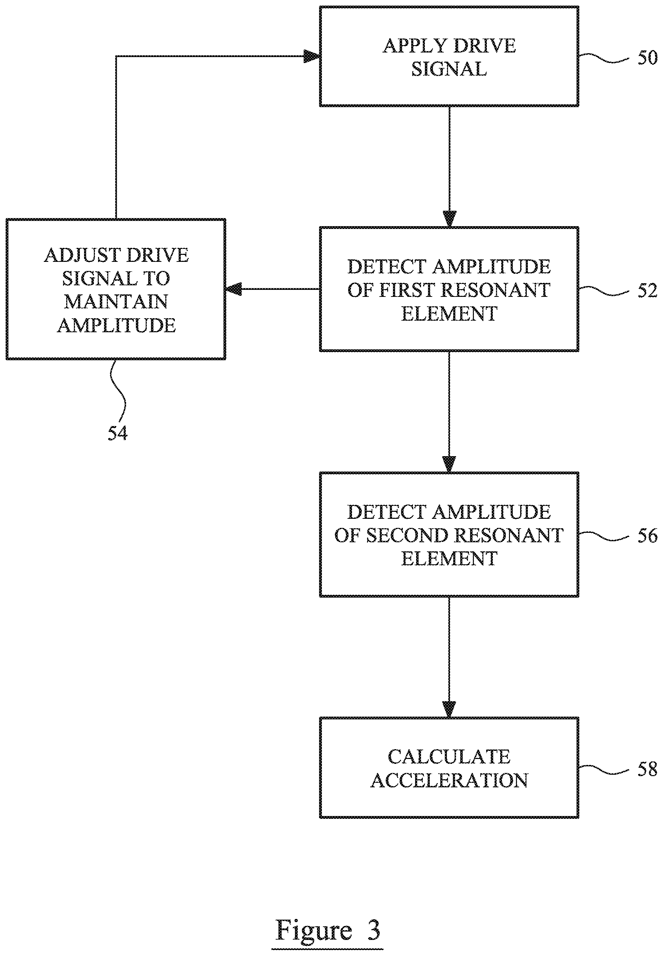

Figure 3 is a flow diagram, illustrating the steps carried out in a method in accordance with the present invention using an accelerometer of the type described above with reference to Figures 1 and 2. In a first step, step 50, the resonant elements are caused to vibrate in a resonant mode using a drive signal. As described above the drive signal may comprise an AC voltage applied to the resonant elements and a DC biasing voltage applied to adjacent electrodes. In step 52, the amplitude of vibration of the first resonant element is detected. In step 54 the drive signal is adjusted to maintain the amplitude of the first resonant element at a constant level using a feedback loop. The amplitude of vibration of the second resonant element is detected in step 56 to provide a measure of the change in effective stiffness of the first resonant element, from which the acceleration or angular velocity of the proof mass along the axis of sensitivity can be determined in step 58.

Figures 4, 5 and 6 illustrate further embodiments that are variations of the accelerometer of Figures 1 and 2.

In Figure 4 a single proof mass 60 is used instead of separate first and second proof masses 10 and 20. The single proof mass is connected to both the first resonant element 16 and the second resonant element 26. In effect, the first and second proof masses of Figure 1 are joined together and surround the first resonant element 16, second resonant element 26 and coupling beam 22. This arrangement operates in exactly the same way as the embodiment of Figure 1, but allows the mass of the proof mass to be maximised for a given footprint of the accelerometer.

The embodiment of Figure 5 is identical to the embodiment of Figure 4 except for the form of the coupling beam between the first and second resonant elements. In the embodiment of Figure 5 the coupling beam 22 is a serpentine shaped beam. The coupling strength provided by a serpentine shaped beam can be less sensitive to temperature fluctuations than a simple linear beam and therefore can result in better common mode rejection of noise due to temperature variations.

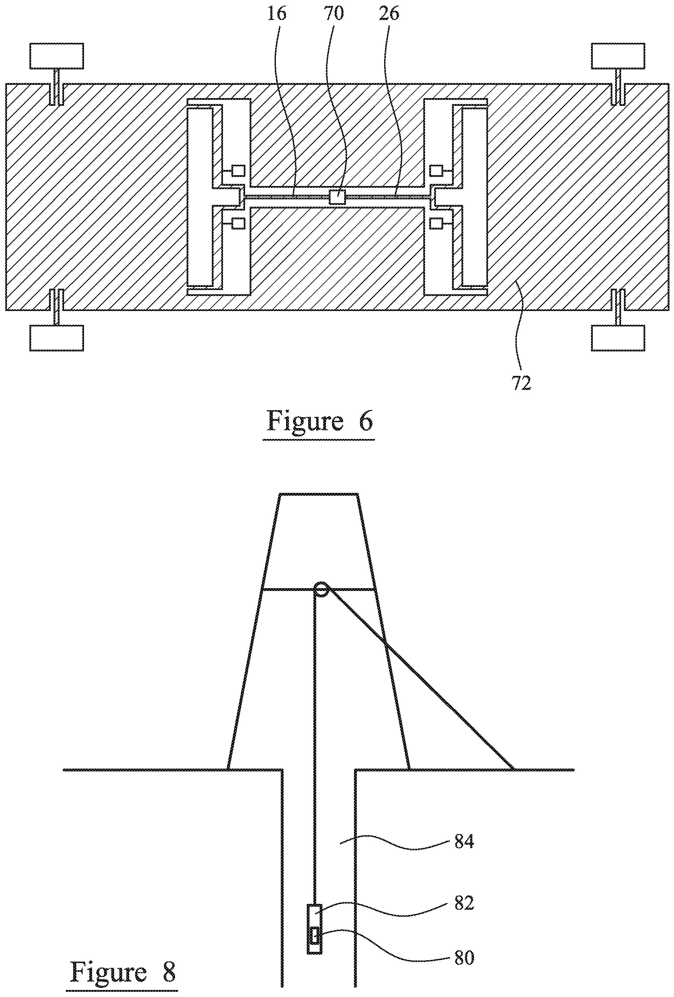

The embodiment of Figure 6 is identical to the embodiment of Figure 4 except for manner in which the coupling between the first and second resonant elements is provided. In the embodiment of Figure 6, the first and second resonant elements 16, 26 are arranged coaxially along the sensitive axis of the accelerometer and coupling between them is provided by a non-ideal anchor 70. A separate coupling beam is not required. This arrangement has the advantage that the sensing axis of the two resonant elements are not offset from one another. It also has the advantage that impact of temperature fluctuations on a coupling beam are removed. However, it can be difficult to achieve a consistent level of coupling between the resonant elements from one device to the next in a manufacturing process.

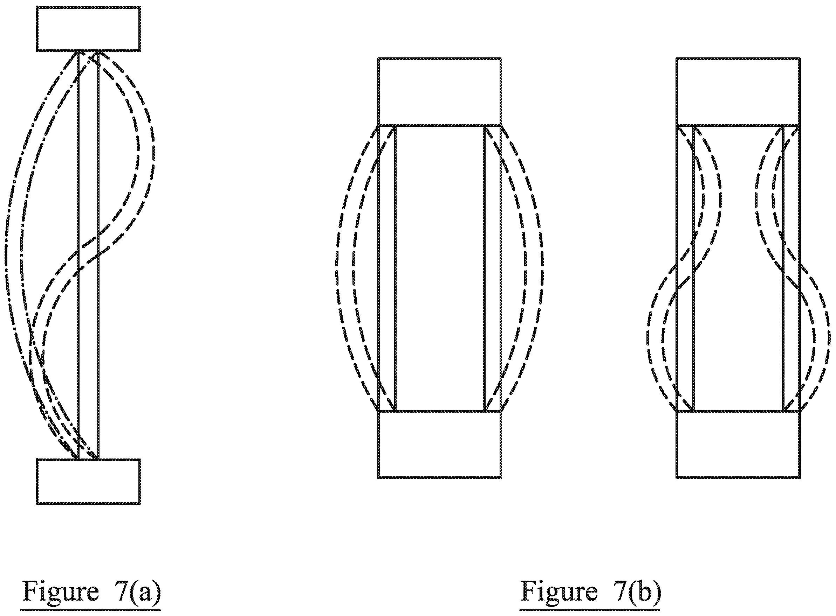

In the embodiments of Figure 1, 4 and 5, the first and second resonant elements 16, 26 may take the form of a simple clamped-clamped beam, as illustrated in Figure 7a or may take the form of a double ended tuning fork (DETF) as shown in Figure 7b. Different modal shapes for the two types of resonant element are illustrated in dotted line in Figure 7.

In the embodiment of Figure 6, in which coupling through the anchor 70 is required, it is advantageous to use a simple clamped-clamped beam, as illustrated in Figure 7a. If DETF elements are employed, they will be operated in the in-phase mode preferentially to enable mechanical coupling between the resonant elements through the anchor.

An accelerometer as described can be used for many applications. One example is as a gravimeter. A gravimeter can be used for surveying in oil or gas extraction. Figure 10 illustrates a gravimeter down a bore hole. Measurements of the gravity field down a borehole can provide information about the density of the surrounding layers and so information about the presence of oil or gas reserves and their size and location. This requires measurement of gravitational filed in three dimensions. A shown in Figure 8, an accelerometer 80 in accordance with the invention is positioned within a borehole tool 82. The borehole tool is placed in the bore 84, suspended from a suitable structure on the surface. Gravimeters of this sort can be used in other applications, such as carbon storage monitoring, monitoring groundwater depletion, discovery of underwater aquifers, monitoring other processes underpinning the hydrological cycle, early-warning systems for earthquake-prone zones or for areas impacted by volcanic activity.

## Claims

1. An accelerometer comprising:
a frame (12);
one or more proof masses (10, 20, 60) suspended from the frame by one or more flexures (14) and movable relative to the frame along a sensing axis;
a resonant element assembly, the resonant element assembly comprising a first resonant element (16) and a second resonant element (26) coupled to one another, the first resonant element connected between the one or more proof masses and the frame, the second resonant element connected between the one or more proof masses and the frame, such that movement of the one or more proof masses relative to the frame along the sensing axis results in one of the first and second resonant elements undergoing compression and the other of the first and second resonant elements undergoing tension; and
drive circuitry configured to drive the resonant element assembly into one or more resonant modes and a sensing circuit configured to determine a measure of acceleration based on changes in resonant behaviour of the first and second resonant elements,
**characterised in that**,
the first resonant element is coupled to the second resonant element by a mechanical coupling (22, 70) or the first and second resonant elements are electrostatically coupled to one another.

2. An accelerometer according to claim 1, wherein the first (16) and second (26) resonant elements are substantially identical.

3. An accelerometer according to claim 1 or 2, wherein the one or more proof masses comprises a single proof mass (60) and the first (16) and second (26) resonant elements are both coupled to the single proof mass.

4. An accelerometer according to claim 3, wherein the first (16) and second (26) resonant elements are surrounded by the single proof mass (60).

5. An accelerometer according to any one of the preceding claims wherein one or both of the first (16) and second (26) resonant elements is connected to the one or more proof masses (10, 20, 60) through a force amplifying lever (18, 28).

6. An accelerometer according to any one of the preceding claims, wherein the first resonant element (16) is connected to the frame (12) at a first anchor and the second resonant element (26) is connected to the frame at a second anchor, and wherein the mechanical coupling (22, 70) is positioned at or close to a nodal point of a mode of vibration of the resonant element assembly.

7. An accelerometer according to any one of the preceding claims, wherein the mechanical coupling (70) is a portion of the frame (12), the first (16) and second (26) resonant elements being connected to the frame at a common anchor.

8. An accelerometer according to any one of the preceding claims, wherein the mechanical coupling (22) comprises a serpentine beam.

9. An accelerometer according to any one of the preceding claims, comprising a third resonant element (17) coupled to one or both of the first (16) and second (26) resonant elements.

10. An accelerometer according to claim 9, wherein the third resonant element (17) has different mechanical properties to the first resonant element (16) and the second resonant element (26).

11. An accelerometer according to claim 10, wherein the third resonant element (17) has a different stiffness to the first resonant element (16) and the second resonant element (26).

12. An accelerometer according to any one of the preceding claims, wherein the drive circuitry is configured to provide a parametric pumping signal to the resonant element assembly.

13. An accelerometer according to any one of the preceding claims, wherein the sensing circuitry is configured to provide an output based on the amplitudes of vibration of the first resonant element (16) and the second resonant element (26).

14. A gravimeter comprising an accelerometer according to any one of the preceding claims.

15. A borehole tool comprising one or more accelerometers in accordance with claims 1 to 13.

## Patentansprüche

1. Beschleunigungsmesser, umfassend:
einen Rahmen (12);
eine oder mehrere Prüfmassen (10, 20, 60), die durch ein oder mehrere Biegeelemente (14) am Rahmen aufgehängt sind und relativ zum Rahmen entlang einer Messachse bewegbar sind;
eine Resonanzelementanordnung, wobei die Resonanzelementanordnung ein erstes Resonanzelement (16) und ein zweites Resonanzelement (26) umfasst, die miteinander gekoppelt sind, wobei das erste Resonanzelement zwischen der einen oder den mehreren Prüfmassen und dem Rahmen befestigt ist, das zweite Resonanzelement zwischen der einen oder den mehreren Prüfmassen und dem Rahmen befestigt sind, so dass die Bewegung der einen oder mehreren Prüfmassen entlang der Messachse relativ zum Rahmen dazu führt, dass eines von dem ersten und dem zweiten Resonanzelement auf Druck beansprucht wird und das andere von dem ersten und zweiten Resonanzelement auf Zug beansprucht wird; und
eine Ansteuerschaltungsanordnung zum Ansteuern der Resonanzelementanordnung zu einem oder mehreren Resonanzmodi und eine Messschaltung, die zum Ermitteln eines Beschleunigungsmaßes auf Basis von Änderungen des Resonanzverhaltens des ersten und des zweiten Resonanzelements konfiguriert ist,
**dadurch gekennzeichnet, dass**
das erste Resonanzelement durch eine mechanische Kopplung (22, 70) mit dem zweiten Resonanzelement gekoppelt ist oder das erste und das zweite Resonanzelement elektrostatisch miteinander gekoppelt sind.

2. Beschleunigungsmesser nach Anspruch 1, wobei das erste (16) und das zweite (26) Resonanzelement im Wesentlichen identisch sind.

3. Beschleunigungsmesser nach Anspruch 1 oder 2, wobei die eine oder mehreren Prüfmassen eine einzelne Prüfmasse (60) umfassen und das erste (16) und das zweite (26) Resonanzelement beide mit der einzelnen Prüfmasse gekoppelt sind.

4. Beschleunigungsmesser nach Anspruch 3, wobei das erste (16) und das zweite (26) Resonanzelement von der einzelnen Prüfmasse (60) umgeben sind.

5. Beschleunigungsmesser nach einem der vorhergehenden Ansprüche, wobei das erste (16) und/oder das zweite Resonanzelement durch einen kraftverstärkenden Hebel (18, 28) mit der einen oder den mehreren Prüfmassen (10, 20, 60) verbunden ist.

6. Beschleunigungsmesser nach einem der vorhergehenden Ansprüche, wobei das erste Resonanzelement (16) an einem ersten Anker mit dem Rahmen (12) verbunden ist und das zweite Resonanzelement (26) an einem zweiten Anker mit dem Rahmen verbunden ist und wobei die mechanische Kopplung (22, 70) an oder nahe an einem Knotenpunkt einer Schwingungsform der Resonanzelementanordnung positioniert ist.

7. Beschleunigungsmesser nach einem der vorhergehenden Ansprüche, wobei die mechanische Kopplung (70) ein Teil des Rahmens (12) ist, wobei das erste (16) und das zweite (26) Resonanzelement an einem gemeinsamen Anker mit dem Rahmen (12) verbunden sind.

8. Beschleunigungsmesser nach einem der vorhergehenden Ansprüche, wobei die mechanische Kopplung (22) einen mäanderförmigen Balken umfasst.

9. Beschleunigungsmesser nach einem der vorhergehenden Ansprüche, der ein drittes Resonanzelement (17) umfasst, das mit dem ersten (16) und/oder dem zweiten (26) Resonanzelement gekoppelt ist.

10. Beschleunigungsmesser nach Anspruch 9, wobei das dritte Resonanzelement (17) andere mechanische Eigenschaften als das erste Resonanzelement (16) und das zweite Resonanzelement (26) aufweist.

11. Beschleunigungsmesser nach Anspruch 10, wobei das dritte Resonanzelement (17) eine andere Steifigkeit als das erste Resonanzelement (16) und das zweite Resonanzelement (26) aufweist.

12. Beschleunigungsmesser nach einem der vorhergehenden Ansprüche, wobei die Ansteuerungsschaltungsanordnung zum Anlegen eines parametrischen Pumpwellensignals an die Resonanzelementanordnung konfiguriert ist.

13. Beschleunigungsmesser nach einem der vorhergehenden Ansprüche, wobei die Messschaltungsanordnung zum Bereitstellen eines Ausgangs auf Basis der Schwingungsamplituden des ersten Resonanzelements (16) und des zweiten Resonanzelements (26) konfiguriert ist.

14. Gravimeter, das einen Beschleunigungsmesser nach einem der vorhergehenden Ansprüche aufweist.

15. Bohrlochwerkzeug, das einen oder mehrere Beschleunigungsmesser nach den Ansprüchen 1 bis 13 umfasst.

## Revendications

1. Accéléromètre comprenant :
un cadre (12) ;
une ou plusieurs masses étalons (10, 20, 60) suspendues au cadre par un ou plusieurs éléments flexibles (14) et mobiles par rapport au cadre le long d'un axe de détection ;
un ensemble d'éléments résonnants, l'ensemble d'éléments résonnants comprenant un premier élément résonnant (16) et un deuxième élément résonnant (26) couplés l'un à l'autre, le premier élément résonnant étant connecté entre les une ou plusieurs masses étalons et le cadre, le deuxième élément résonnant étant connecté entre les une ou plusieurs masses étalons et le cadre, de telle sorte que le mouvement des une ou plusieurs masses étalons par rapport au cadre le long de l'axe de détection cause une compression d'un des premier et deuxième éléments résonnants et une tension de l'autre des premier et deuxième éléments résonnants ; et
une circuiterie d'entraînement configurée pour commander l'ensemble d'éléments résonnants dans un ou plusieurs modes de résonance et un circuit de détection configuré pour déterminer une mesure d'accélération en fonction de changements du comportement résonnant des premier et deuxième éléments résonnants,
**caractérisé en ce que**
le premier élément résonnant est couplé au deuxième élément résonnant par un raccord mécanique (22, 70) ou les premier et deuxième éléments résonnants sont couplés électrostatiquement l'un à l'autre.

2. Accéléromètre selon la revendication 1, dans lequel les premier (16) et deuxième (26) éléments résonnants sont sensiblement identiques.

3. Accéléromètre selon la revendication 1 ou 2, dans lequel les une ou plusieurs masses étalons comprennent une masse étalon unique (60) et les premier (16) et deuxième (26) éléments résonnants sont tous deux couplés à la masse étalon unique.

4. Accéléromètre selon la revendication 3, dans lequel les premier (16) et deuxième (26) éléments résonnants sont entourés par la masse étalon unique (60).

5. Accéléromètre selon l'une quelconque des revendications précédentes, dans lequel l'un ou les deux des premier (16) et deuxième (26) éléments résonnants est connecté à une ou plusieurs masses étalons (10, 20, 60) par l'intermédiaire d'un levier amplificateur de force (18, 28).

6. Accéléromètre selon l'une quelconque des revendications précédentes, dans lequel le premier élément résonnant (16) est connecté au cadre (12) au niveau d'un premier ancrage et le deuxième élément résonnant (26) est connecté au cadre au niveau d'un deuxième ancrage, et dans lequel le couplage mécanique (22, 70) est positionné au niveau ou à proximité d'un point nodal d'un mode de vibration de l'ensemble d'éléments résonnants.

7. Accéléromètre selon l'une quelconque des revendications précédentes, dans lequel le couplage mécanique (70) est une partie du cadre (12), les premier (16) et deuxième (26) éléments résonnants étant connectés au cadre au niveau d'un ancrage commun.

8. Accéléromètre selon l'une quelconque des revendications précédentes, dans lequel le raccord mécanique (22) comprend un montant en S.

9. Accéléromètre selon l'une quelconque des revendications précédentes, comprenant un troisième élément résonnant (17) 15 couplé à l'un ou l'autre des premier (16) et deuxième (26) éléments résonnants, ou aux deux.

10. Accéléromètre selon la revendication 9, dans lequel le troisième élément résonnant (17) a des propriétés mécaniques différentes de celles du premier élément résonnant (16) et du deuxième élément résonnant (26).

11. Accéléromètre selon la revendication 10, dans lequel le troisième élément résonnant (17) a une rigidité différente de celle du premier élément résonnant (16) et du deuxième élément résonnant (26).

12. Accéléromètre selon l'une quelconque des revendications précédentes, dans lequel le circuit d'entraînement est configuré pour fournir un signal de pompage paramétrique à l'ensemble d'éléments résonnants.

13. Accéléromètre selon l'une quelconque des revendications précédentes, dans lequel le circuit de détection est configuré pour fournir une sortie basée sur les amplitudes de vibration du premier élément résonnant (16) et du deuxième élément résonnant (26).

14. Gravimètre comprenant un accéléromètre selon l'une quelconque des revendications précédentes.

15. Outil de forage comprenant un ou plusieurs accéléromètres selon les revendications 1 à 13.
